(19) **Europäisches Patentamt / European Patent Office / Office européen des brevets**

(11) **EP 4 459 497 A1**

(12) **EUROPEAN PATENT APPLICATION**
published in accordance with Art. 153(4) EPC

(43) Date of publication:
06.11.2024 Bulletin 2024/45

(51) International Patent Classification (IPC):
*G06F 30/27* (2020.01)

(21) Application number: 22913678.3

(22) Date of filing: 18.10.2022

(52) Cooperative Patent Classification (CPC):
Y02E 30/00

(86) International application number:
PCT/CN2022/125854

(87) International publication number:
WO 2023/124414 (06.07.2023 Gazette 2023/27)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 31.12.2021 CN 202111676363

(71) Applicants:
• Ling Dong Nuclear Power Co., Ltd
Shenzhen, Guangdong 518000 (CN)
• China Nuclear Power Technology Research
Institute Co., Ltd.
Shenzhen, Guangdong 518031 (CN)
• China General Nuclear Power Corporation
Shenzhen, Guangdong 518028 (CN)
• CGN Power Co., Ltd.
Shenzen, Guangdong 518028 (CN)

(72) Inventors:
• DING, Peng
Shenzhen, Guangdong 518031 (CN)
• CHEN, Shu
Shenzhen, Guangdong 518031 (CN)
• LI, Wenhuai
Shenzhen, Guangdong 518031 (CN)
• XIA, Wenqing
Shenzhen, Guangdong 518031 (CN)
• YU, Fengwan
Shenzhen, Guangdong 518031 (CN)
• DUAN, Chengjie
Shenzhen, Guangdong 518031 (CN)
• CUI, Dawei
Shenzhen, Guangdong 518031 (CN)
• LIN, Jiming
Shenzhen, Guangdong 518031 (CN)

(74) Representative: Michalski Hüttermann & Partner
Patentanwälte mbB
Kaistraße 16A
40221 Düsseldorf (DE)

(54) **NUCLEAR REACTOR DESIGN SCHEME OPTIMIZATION METHOD AND APPARATUS, COMPUTER DEVICE, AND MEDIUM**

(57) A nuclear reactor design scheme optimization method and apparatus, a computer device, a storage medium, and a computer program product. The method comprises: acquiring an overall machine learning model of a nuclear reactor; according to the overall machine learning model of the nuclear reactor, searching for a nuclear reactor design scheme using an optimization algorithm, to obtain a nuclear reactor design scheme search result; performing validation and regression of the nuclear reactor design scheme search result; and generating an optimized nuclear reactor design scheme according to a validation and regression result. In the whole process, diversified nuclear reactor design schemes are generated using a machine learning model, and an optimization algorithm is used to perform a search of the schemes, and to perform subsequent validation and regression, so that an optimized nuclear reactor design scheme can be generated efficiently while ensuring the accuracy of scheme construction.

(Cont. next page)

EP 4 459 497 A1

| a nuclear reactor overall machine learning model is acquired | — S200 |

↓

| a nuclear reactor design scheme is searched for with an optimization algorithm according to the nuclear reactor overall machine learning model, a search result of the nuclear reactor design scheme is obtained | — S400 |

↓

| a verification regression is performed on the search result of the nuclear reactor design scheme | — S600 |

↓

| a nuclear reactor design optimization scheme is generated according to a verification regression result | — S800 |

FIG. 2

**Description**

**CROSS-REFERENCE TO RELATED APPLICATION**

The present application claims priority to Chinese Patent Application with No. 202111676363.3, entitled "Nuclear Reactor Design Scheme Optimization Method and Apparatus, Computer Device, and Medium", and filed on December 31, 2021, the content of which is expressly incorporated herein by reference in its entirety.

**TECHNICAL FIELD**

The present application relates to the field of big data technology, and particularly to a nuclear reactor design scheme optimization method and apparatus, a computer device, a storage medium, and a computer program product.

**BACKGROUND**

The generation of a nuclear reactor design scheme is a prerequisite and an important link in the engineering construction and safe operation of the nuclear reactor.

The design of the nuclear reactor involves many disciplines, complex physical phenomena, and highly nonlinear problems. The design of the nuclear reactor involves many disciplines including physics, shielding, fuel, thermal engineering, and safety analysis, etc. In a preliminary nuclear reactor scheme, reasonable overall parameters are selected according to the application scenario, and then the relevant designs are carried out in physics, thermal engineering, safety analysis, and equipment mechanics in sequence. The nuclear reactor design process involves a long iterative loop of multi-disciplinary designs, a low efficiency, and a low accuracy. Documents and design parameters need to be transferred between disciplines. This process requires a lot of human resources. It often happens that when downstream professionals find that the design parameters are unreasonable, the entire scheme should be redesigned and finalized by upstream professionals, because the upstream professionals are unable to directly consider the impact of the downstream disciplines during the design and evaluation processes. During the transmission of partial computational data, errors and mistakes may occur in the processing and interfacing by the professionals. All of the above may lead to a long actual design loop and a low efficiency of the nuclear reactor.

Accordingly, there is an urgent need for an efficient nuclear reactor design scheme optimization solution.

**SUMMARY**

According to the embodiments of the present invention, an efficient nuclear reactor design scheme optimization method and apparatus, a computer device, a computer-readable storage medium, and a computer program product are provided.

A nuclear reactor design scheme optimization method is provided, including:

acquiring a nuclear reactor overall machine learning model;
searching for a nuclear reactor design scheme with an optimization algorithm according to the nuclear reactor overall machine learning model, obtaining a search result of the nuclear reactor design scheme;
performing a verification regression on the search result of the nuclear reactor design scheme; and
generating a nuclear reactor design optimization scheme according to a verification regression result.

A nuclear reactor design scheme optimization apparatus is provided, including:

a model acquisition module, configured to acquire a nuclear reactor overall machine learning model;
a search module, configured to search for a nuclear reactor design scheme using an optimization algorithm according to the nuclear reactor overall machine learning model, and obtain a search result of the nuclear reactor design scheme;
a verification module, configured to perform a verification regression on the search result of the nuclear reactor design scheme; and
a scheme generation module, configured to generate a nuclear reactor design optimization scheme according to a verification regression result.

A computer device is provided, including one or more processors and a memory storing computer-readable instructions. The computer-readable instructions, when executed by the one or more processors, cause the one or more processors to implement steps of:

acquiring a nuclear reactor overall machine learning model;

searching for a nuclear reactor design scheme with an optimization algorithm according to the nuclear reactor overall machine learning model, obtaining a search result of the nuclear reactor design scheme;

performing a verification regression on the search result of the nuclear reactor design scheme; and

generating a nuclear reactor design optimization scheme according to a verification regression result.

One or more computer storage media are provided, on which computer-readable instructions are stored. The the computer-readable instructions, when executed by the one or more processors, cause the one or more processors to implement steps of:

acquiring a nuclear reactor overall machine learning model;

searching for a nuclear reactor design scheme with an optimization algorithm according to the nuclear reactor overall machine learning model, obtaining a search result of the nuclear reactor design scheme;

performing a verification regression on the search result of the nuclear reactor design scheme; and

generating a nuclear reactor design optimization scheme according to a verification regression result.

A computer program product is provided, including a computer program. The computer program, when executed by a processor, causes the processor to implement steps of:

acquiring a nuclear reactor overall machine learning model;

searching for a nuclear reactor design scheme with an optimization algorithm according to the nuclear reactor overall machine learning model, obtaining a search result of the nuclear reactor design scheme;

performing a verification regression on the search result of the nuclear reactor design scheme; and

generating a nuclear reactor design optimization scheme according to a verification regression result.

The details of one or more embodiments of the present invention are set forth in the accompanying drawings and the description below. Other features and advantages of the present application will be apparent from the description, drawings, and claims.

BRIEF DESCRIPTION OF THE DRAWINGS

In order to more clearly illustrate the technical solution in the embodiments of the present invention, the accompanying drawings required for use in the embodiments will be briefly introduced below. Obviously, the drawings described below are merely some embodiments of the present invention. Those skilled in the art may obtain other drawings based on these drawings without any creative effort.

FIG. 1 is an application environment diagram of a nuclear reactor design scheme optimization method according to an embodiment.

FIG. 2 is a schematic flow chart of a nuclear reactor design scheme optimization method according to an embodiment.

FIG. 3 is a sub-flow chart of S200 according to an embodiment.

FIG. 4 is a sub-flow chart of S400 according to an embodiment.

FIG. 5 is a flow chart of an optimization algorithm of NSGA-II.

FIG. 6 is a sub-flow chart of S600 according to an embodiment.

FIG. 7 is a schematic diagram of a regression verification process according to an embodiment.

FIG. 8 is a block diagram of a nuclear reactor design scheme optimization apparatus according to an embodiment.

FIG. 9 is an internal structure diagram of a computer device according to an embodiment.

DETAILED DESCRIPTION

In order to make the technical solution and advantages of the present invention more clear to understand, the present invention is elaborated below in conjunction with the accompanying drawings and embodiments. It should be appreciated that the specific embodiments described herein are merely used for explaining the present invention, rather than limiting the present application.

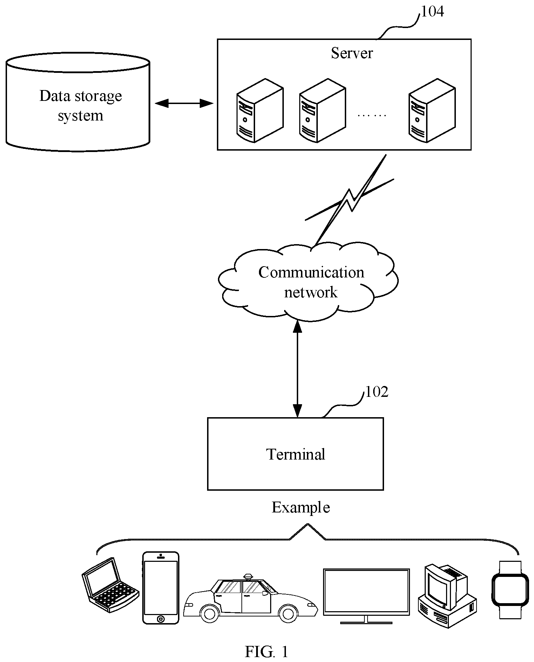

The nuclear reactor design scheme optimization method provided in the embodiments of the present invention can be applied in the application environment shown in FIG. 1. A terminal 102 is in communication with a server 104 through a network. A data storage system may store data that the server 104 needs to process. The data storage system may be integrated on the server 104 or placed on a cloud or other network servers. The terminal 102 transmits a nuclear reactor design scheme optimization request to the server 104. The server 104 acquires a nuclear reactor overall machine learning model, searches for a nuclear reactor design scheme by using an optimization algorithm according to the nuclear reactor overall machine learning model, obtains a search result of the nuclear reactor design scheme, performs a verification regression on the search result of the nuclear reactor design scheme, and generates a nuclear reactor design optimization scheme according to a verification regression result. Optionally, the server 104 may further feed back the generated nuclear reactor design optimization scheme to the terminal 102. The terminal 102 may be, but not limited to, various personal computers, laptops, smart phones, tablets, Internet of Things devices and portable wearable devices. The Internet of Things devices may be smart speakers, smart TVs, smart air conditioners, smart car-mounted devices, etc. The portable wearable devices may be smart watches, smart bracelets, head-mounted devices, etc. The server 104 may be implemented as an independent server or a server cluster consisting of a plurality of servers.

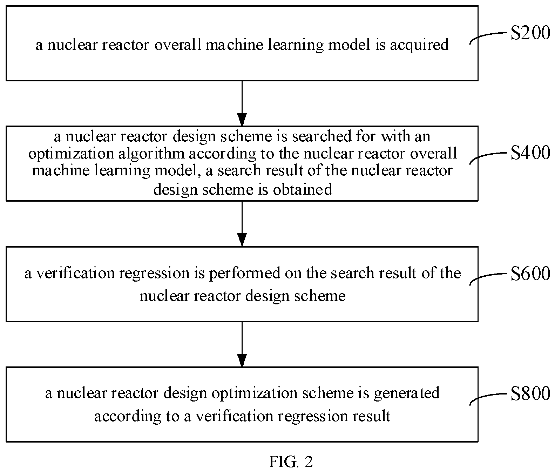

In an embodiment, as shown in FIG. 2, a nuclear reactor design scheme optimization method is provided, which is applied to the server 104 shown in FIG. 1 as an example for illustration, and the method may include the following steps.

S200: a nuclear reactor overall machine learning model is acquired.

The nuclear reactor overall machine learning model refers to a machine learning model for the entire nuclear reactor, which may specifically include a nuclear reactor physical model, a nuclear reactor thermal model, and a nuclear reactor safety analysis and evaluation model. The nuclear reactor overall machine learning model may be obtained by a temporary generation, or by directly using a pre-built model. If the nuclear reactor overall machine learning model is acquired by a temporary construction, it is necessary to first acquire design parameters of the nuclear reactor. The design parameters may include a seed physical parameter, a thermal and hydraulic parameter, a fuel parameter, a system parameter, and a safety analysis result parameter, etc. The nuclear reactor overall machine learning model is obtained by training with a supervised learning mode based on the above parameters.

S400: a nuclear reactor design scheme is searched for with an optimization algorithm according to the nuclear reactor overall machine learning model, a search result of the nuclear reactor design scheme is obtained.

A variety of nuclear reactor design schemes may be generated according to the nuclear reactor overall machine learning model. There exists an optimized design scheme in these design schemes. Accordingly, an optimization algorithm is utilized to search for the nuclear reactor design scheme to obtain the search result of the nuclear reactor design scheme. Specifically, the optimization algorithm may include a composite multi-optimization method or a multi-target optimization algorithm, through which the optimized design scheme is searched for, and the search result can be extracted.

S600: a verification regression is performed on the search result of the nuclear reactor design scheme.

There exists an optimized nuclear reactor design scheme in the search result of the nuclear reactor design scheme. The optimized nuclear reactor design scheme is verified to determine whether the design scheme is accurate. If the design scheme is accurate, a regression correction is performed on the nuclear reactor overall machine learning model according to the design scheme. If the design solution is inaccurate, the process returns to S400 to restart a new round of search of the nuclear reactor design scheme.

S800: a nuclear reactor design optimization scheme is generated according to a verification regression result.

As mentioned above, if the verification regression result is characterized as pass, the regression correction is performed on the nuclear reactor overall machine learning model according to the design scheme, and the final nuclear reactor design optimization scheme is generated according to the corrected nuclear reactor overall machine learning model. If the verification regression result is characterized as failure, the process returns to S400 to continue to start a new search of the nuclear reactor design scheme.

In the above-mentioned nuclear reactor design scheme optimization method, the nuclear reactor overall machine learning model is acquired, the nuclear reactor design scheme is searched for with the optimization algorithm according to the nuclear reactor overall machine learning model, the search result of the nuclear reactor design scheme is obtained, the verification regression is performed on the search result of the nuclear reactor design scheme, and the nuclear reactor design optimization scheme is generated according to the verification regression result. During the entire process, a variety of nuclear reactor design schemes are generated through the machine learning model, and the optimization algorithm is utilized to search for the scheme and the verification regression is performed subsequently, which can efficiently generate the nuclear reactor design optimization scheme on the premise of ensuring that the scheme is accurately constructed.

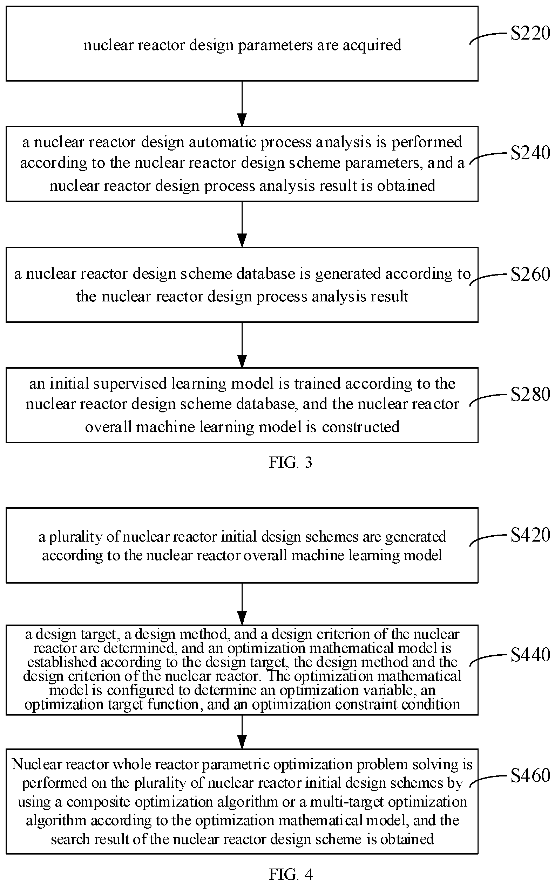

As shown in FIG. 3, in an embodiment, S200 may include the following steps.

S220: nuclear reactor design parameters are acquired.

A nuclear reactor parameter table is established here. According to different types of data, the parameters can be divided into design input parameters and response parameters. The design input parameters may include a design scheme parameter such as geometry, structure, and material, etc., and an upstream professional computational analysis result. Furthermore, some of the initial parameters are not completely independent. If the input parameters are not independent, a feasible domain of the generated design scheme may become smaller. Therefore, preferably, a nuclear reactor design parameter table may be acquired. The design parameters in the nuclear reactor design parameter table are independently transformed to obtain nuclear reactor design scheme parameters. That is, in the process of design input parameterization, the design parameters are transformed independently, which can both reduce the dimension of the design parameters and increase the feasible domain of the design computation. In addition, in order to better set a range of each variable, the design variables need to be preprocessed to reduce a degree of correlation between variables, for example, a fuel element diameter, a fuel rod inner diameter, and an outer diameter, are transformed into a fuel rod diameter, an air gap diameter, and a cladding thickness.

S240: a nuclear reactor design automatic process analysis is performed according to the nuclear reactor design scheme parameters, and a nuclear reactor design process analysis result is obtained.

In the design process of the nuclear reactor, it is necessary to consider the reactor core neutron physics computation, the reactor core thermal hydraulics, the structural design, and the thermal system design. Accordingly, in addition to a target function, such as volume, weight, and economic indicators, it is also necessary to consider the safety, such as a reactivity keff, a service life, a reactivity coefficient, a fuel temperature, a coolant flow rate, a temperature, and other neutron physics design criteria, a thermal hydraulics criterion, and a structural design criterion. Firstly, a parametric design scheme is randomly generated, and input cards of various design tools are automatically generated by using the parametric design scheme; then, the various design tools are linked together by using an external coupling mode according to the conventional design idea; and then the design tools operate automatically. It should be particularly noted that in this process, multi-threaded concurrent or CPU multi-core parallel methods can be utilized to accelerate the computation and improve the computational efficiency, and the final design result is provided.

S260: a nuclear reactor design scheme database is generated according to the nuclear reactor design process analysis result.

An extraction tool is established to match a design scheme with a design analysis result, and finally a nuclear reactor design scheme evaluation database is formed. Firstly, a parametric design scheme is extracted, and then an analysis result is extracted, which includes a target value and a limit value. Data contained in the database actually established is shown in Table 1 below.

Table 1 showing examples of data contained in database

| Serial number | Design parameter 1 (pellet material) | Design parameter 2 (pellet and cladding filling) | ...... | Design parameter N | Response parameter 1 (keff at beginning of loop) | ...... | Response parameter M |
|---|---|---|---|---|---|---|---|
| 1 | UO2 | He | ...... | ...... | ...... | ...... | ...... |
| ...... | ...... | ...... | ...... | ...... | ...... | ...... | ...... |

S280: an initial supervised learning model is trained according to the nuclear reactor design scheme database, and the nuclear reactor overall machine learning model is constructed.

In the step, machine learning is utilized to establish the nuclear reactor analysis and evaluation model. The machine learning model includes a supervised learning model such as a generalized linear model, a vector machine model, a stochastic gradient descent model, a Bayesian model, a decision tree model, and a random forest model, etc. Firstly, the database generated at the step S260 is read, and then design variables are preprocessed, which may include standardization, normalization, nonlinear transformation, category feature encoding, etc. Secondly, a corresponding machine learning model is established, such as the keff prediction model, a service life prediction model, and a maximum temperature prediction model. Then, an evaluation and an uncertainty analysis are performed on the model, and a prediction error is obtained. Through multiple generations, a reasonable nuclear reactor analysis and evaluation model is finally saved. For example, design parameter 1, UO2 number 1, UN number 2, MOX number. The design parameter can be obtained by computation through the following formula:

$$\alpha_{i,\ j}^{norm} = \alpha_i^{\min} + \frac{a_{i,j} - \alpha_i^{\max}}{\alpha_i^{\max} - \alpha_i^{\min}} \ ;$$

$\alpha_{i,j}$ denotes the j-th parameter in the i-th group, $\alpha_{i,\ j}^{norm}$ denotes a homogenization value of the j-th parameter in the *i*-th group, $\alpha_i^{\max}$ denotes a maximum value of the *i*-th group parameter, $\alpha_i^{\min}$ denotes a minimum value of the i-th group parameter.

As shown in FIG. 4, in an embodiment, S400 may include following steps.

S420: a plurality of nuclear reactor initial design schemes are generated according to the nuclear reactor overall machine learning model.

The design parameters involved in the overall design process of the nuclear reactor are simulated through the nuclear reactor overall machine learning model, and a plurality of nuclear reactor initial design schemes are generated by adjusting the design parameters.

S440: a design target, a design method, and a design criterion of the nuclear reactor are determined, and an optimization mathematical model is established according to the design target, the design method and the design criterion of the nuclear reactor. The optimization mathematical model is configured to determine an optimization variable, an optimization target function, and an optimization constraint condition.

The server responds to a design requirement of a designer and determines the optimization design problem, including (1) a design target, (2) a design method, and (3) a design criterion. The design target refers to a specific application scenario of a nuclear reactor designed, such as power supply in aerospace, ships, deep sea, polar regions, islands, etc. The overall main parameters of the nuclear reactor, such as power and service life of the nuclear reactor, can be determined according to the design targets. The design method refers to a computational analysis method of the nuclear reactor as a whole, a device or a system. The analysis content may include physics, fuel, thermal engineering, system, safety analyses, etc. The physical analysis can be performed by using deterministic software or Monte Carlo software. The thermal hydraulics may use sub-channels, etc. The design criterion may include a neutron physics design criterion, a thermal design criterion, a structural design criterion, etc. The typical neutron physics design criterion includes a reactivity temperature coefficient, a maximum controllable reactivity introduction rate, a shutdown margin, burnup, etc. The thermal design criterion includes a fuel temperature limitation, a cladding thermal limit, and a coolant temperature limit. The reactor core structural design criterion mainly satisfies the existing relevant specifications. For example, in order to optimize the economic efficiency of the nuclear reactor, uranium loading may serve as an optimization target.

The establishment of the mathematical model includes: (1) selection of a decision variable, 2) determination of a target function, and 3) clarification of a design requirement, setting of a constraint condition, and input of a setting range. The decision variable, also referred to as an optimization variable, refers to an independent parameter which is adjustable and selectable in a target optimization design problem. The nuclear reactor design problem may include n decision variables, indicating that the nuclear design problem is an n-dimensional optimization problem. The types of decision variables may include a continuous type and a discrete type. These design variables are derived from the design parameters of the nuclear reactor, and each variable is relatively independent. The target function refers to a design target of a nuclear reactor, such as an optimum nuclear reactor arrangement scheme, a minimum volume, a minimum weight, and a maximum economy. The nuclear reactor optimization process is essentially a process of finding a decision variable (design scheme parameter) enabling the target function to reach an optimal value. The target function is a scalar function of a decision variable. The optimal value of the target function is generally expressed in the form of a minimum (or maximum) value. The constraint condition refers to a condition for limiting a value of a decision variable. In the optimization process, the constraint condition is also a function of a decision variable and a function of a nuclear reactor scheme parameter. According to properties of constraints, the constraints can be divided into two categories: a performance constraint and a side constraint. The performance constraint is mainly to satisfy a performance indicator and a design requirement, such as a safety limit, a design criterion, a geometric limit, etc., of a nuclear reactor. The side constraint may include upper and lower limits given to a decision variable. The general model is provided as follows.

The decision variable or optimization variable is usually expressed as:

$$\mathbf{x} = \left[ x_1, x_2, \cdots, x_n \right] \quad (1)$$

The target function is expressed as:

$$\min f(\mathbf{x}) = \min f(x_1, x_2, \cdots, x_n) \quad (2)$$

The multi-target function can be expressed as:

$$\min F(\mathbf{x}) = \min \left[ f_1(\mathbf{x}), f_2(\mathbf{x}), \cdots, f_m(\mathbf{x}) \right] \quad (3)$$

For the multi-target optimization problem, the ideal situation is that the optimization sub-target functions $f_i(\mathbf{x})$ reach the minimum values simultaneously. However, in the actual computations, it is difficult to achieve. In order to deal with the conflicting design targets, a "preferred solution" approach and a "non-dominated solution" approach can be employed. The "preferred solution" approach is to sort and combine various target functions by performing a value determination on each target function. Such an approach relies on the design experience and subjective opinions of the designer or individual. The preferred solution approach can be summarized as: a weight-sum approach, a dictionary order approach, a compromise approach, etc. The non-dominated solution approach minimizes each sub-target function without weakening each sub-target function. The non-dominated solution approach may include: a vector evaluation genetic approach, a non-dominated solution sorting algorithm, a distance algorithm, and an immune memory clone constraint algorithm. The restriction function can be expressed as:

$$g_i(x) \leq 0, \ i = 1, 2 \cdots, q \quad (4)$$

For example, $F(m_{fuel}) = m_{fuel} + \alpha_1(\max(G_1, 0)) + \cdots + \alpha_n(\max(G_n, 0))$ where, $m_{fuel}$ is the uranium loading, $G_1 \ldots G_n$ denote the restriction conditions, and $\alpha_1$ denotes a restriction condition maximum coefficient. Some of the restriction conditions are shown in Table 2 below.

Table 2 showing parameter values corresponding to some restriction conditions

| | |
|---|---|
| Keff at beginning of loop | >1.01 |
| Keff at end of loop | > 1.0 |
| Integral value at beginning of loop | >5000pcm |
| Integral value at end | >5000pcm |
| of loop | Not considered |
| Steady-state maximum fuel temperature Tfuel | <2000°C* stock |
| Strady-state maximum cladding temperature Tclad | <650°C* stock |
| Steady-state maximum cooling temperature Tcout | <600°C* stock |
| Steady-state coolant flowrate (natural circulation) | <2 m/s* stock |

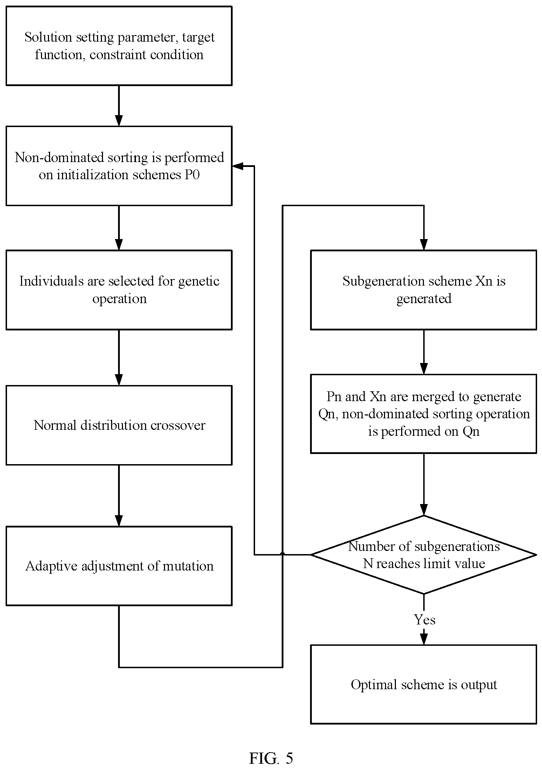

S460: Nuclear reactor whole reactor parametric optimization problem solving is performed on the plurality of nuclear reactor initial design schemes by using a composite optimization algorithm or a multi-target optimization algorithm according to the optimization mathematical model, and the search result of the nuclear reactor design scheme is obtained.
The optimization algorithm may include a composite optimization algorithm or a multi-target optimization algorithm. In order to explain the optimization computation process in detail, an optimization algorithm of the target algorithm NSGA-II is taken as an example to solve the whole reactor parametric optimization problem. As shown in FIG. 5, the entire optimization algorithm may include the following steps.

1. A solution setting parameter, a target function and a constraint condition are confirmed. The setting parameters for NSGA-II at least include the number of initial schemes, an iteration number, a crossover probability, a mutation probability, a crossover mode, a mutation mode, a fitness function option, etc. For example, an initial value of the individual crossover probability is set to 0.9, the mutation probability is 0.03, a population size ranges from 10 to 500, and an evolutionary generation ranges from 50 to 1000. Then, the population size and evolutionary generation are set to the optimal values obtained previously, the crossover probability varies in a range of 0.1 to 0.9, and the mutation probability ranges from 0.01 to 0.8. Now the crossover probability is equal to 0.9, and the mutation probability is equal to 0.03.
2. N initialization schemes P0 are generated in shorthand, and then the non-dominated sorting is performed on N initialization schemes, ranking values of all individuals are initialized, with the maximum generation number n.
3. Individuals are randomly selected from Pn for a genetic operation, then the normal distribution strategy is used for the crossover operation, and an adaptive adjustment of mutation mode is adopted to make a mutation.
4. A sub-generation scheme Xn is generated in the previous step, Pn and Xn are merged to generate Qn and the target function value is computed. A fast non-dominated sorting operation is performed on Qn to compute a crowding degree and a crowding distance of individuals in Qn. N individuals are selected to form a new population Pn+1.
5. When the computation algebra reaches the maximum generation number and the termination condition is met, the loop ends, otherwise turn to step 2.
6. The Pareto optimal solution set is obtained.

Furthermore, after the search result of the nuclear reactor design scheme is obtained, the optimization scheme and the result can be extracted. Specifically, the result can be saved by a serialization operation. The common serialization operation may include marshal, pickle, json, and shelve. The marshal, pickle, and json can use dump and dumps commands to save data, and can use load and loads to read the schemes. The method has a fast loading speed and is easy to read. The computation content of each step in the optimization computation process can be saved and read.

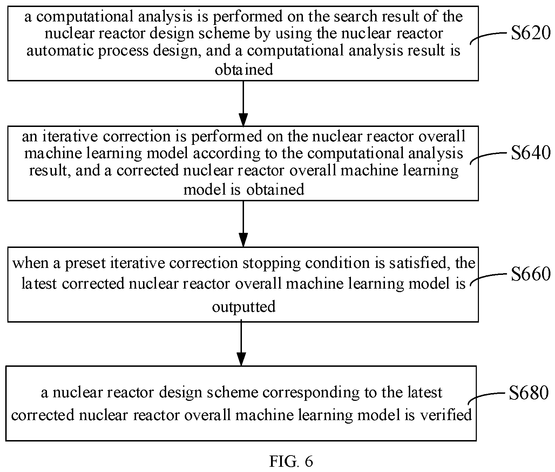

As shown in FIG. 6, in an embodiment, the S600 may include the following steps.

S620: a computational analysis is performed on the search result of the nuclear reactor design scheme by using the nuclear reactor automatic process design, and a computational analysis result is obtained.

Firstly, the automatic process design is reviewed. A plurality of optimized nuclear reactor design schemes included in the search result of the nuclear reactor design scheme are computed and analyzed by using the nuclear reactor automatic process design, and the computational analysis result is obtained. Specifically, the computational analysis may be performed in a similar automatic process design mode as in the S240 above. This process also takes into account the reactor core neutron physics computations, the reactor core thermal hydraulic computations, the structural design, the thermal system design, etc., and various indicators of the target function can be obtained, such as the volume, weight, and the economic indicator. Various parameters in the computations are analyzed, such as the reactivity coefficient, the fuel temperature, the coolant flow rate, the maximum coolant temperature, the maximum fuel temperature, etc. This process can also be accelerated by using the multi-threaded concurrent or multi-core parallel methods.

S640: an iterative correction is performed on the nuclear reactor overall machine learning model according to the computational analysis result, and a corrected nuclear reactor overall machine learning model is obtained.

The iterative correction is performed on the nuclear reactor overall machine learning model according to the computational analysis result generated at the step S620. Specifically, the database corresponding to the nuclear reactor overall machine learning model is updated. On the basis of the updated database, through the preprocessing of the nuclear reactor design scheme parameters, such as standardization, normalization, nonlinear transcoding and other technologies, a machine learning prediction model is established, such as a generalized linear model, a random forest model, a stochastic gradient descent model, etc., and then the evaluation and uncertainty quantification analysis are performed on the model.

S660: when a preset iterative correction stopping condition is satisfied, the latest corrected nuclear reactor overall machine learning model is outputted.

It is determined whether an output condition is satisfied. This step mainly determines whether to output a final design scheme. A common determination criterion may include that the total number of iterations reaches the maximum number limit, and the design scheme parameter outputs the same computation result in the last $nn$ times, where $nn$ is 20 times by default. When the determination result is yes, then it is proceeded to the next step. When the determination result is no, the operation of step S640 is repeated until the determination result is yes.

S680: a nuclear reactor design scheme corresponding to the latest corrected nuclear reactor overall machine learning model is verified.

The latest corrected nuclear reactor overall machine learning model is verified again to verify the accuracy of the design scheme, in order to ensure that an accurate nuclear reactor design scheme is ultimately obtained. Furthermore, an optimization scheme is finally generated and the nuclear reactor engineering design scheme database is completed. The database includes nuclear reactor design schemes, various professional analysis and computation results including physical analysis results and thermal hydraulics analysis results, target function values, constraint condition function values, corresponding machine learning model options and models, and optimization process contents. It should be noted that the scheme parameters and analysis results can be expanded to reduce repeated computations. With the expansion of the breadth and depth of the design, the corresponding models and optimization schemes may become more accurate.

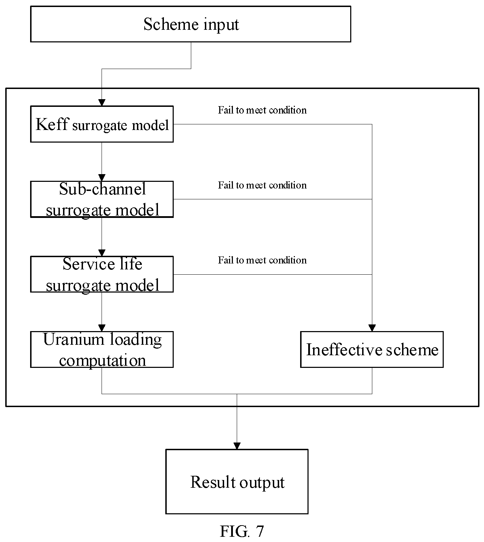

For example, in a multi-layer machine learning surrogate model, a gradient boosting regression tree model is used for the efficient gain coefficient $k_{eff}$, and an extreme random forest model is used for thermal analysis and computations of $T_{cool}^{\max}$, $T_{clad}^{\max}$ and $T_{fule}^{\max}$. The specific regression verification process is shown in FIG. 7. During the optimization process, the database is updated as shown in Table 3 below.

Table 3 showing a data table of the updated database during the optimization process

| Serial number | Design parameter 1 (pellet material) | Design parameter 2 (pellet and cladding filling) | ...... | Design parameter N | Response parameter 1 (keff at beginning of loop) | ...... | Response parameter M |
|---|---|---|---|---|---|---|---|
| 1 | UO2 | He | ...... | ...... | ...... | ...... | ...... |
| ...... | ...... | ...... | ...... | ...... | ...... | ...... | ...... |

(continued)

| Serial number | Design parameter 1 (pellet material) | Design parameter 2 (pellet and cladding filling) | ...... | Design parameter N | Response parameter 1 (keff at beginning of loop) | ...... | Response parameter M |
|---|---|---|---|---|---|---|---|
| i-th group | | | | | computed value of surrogate model is changed to computed value in optimization process | | |
| Potential optimal scheme | ...... | ...... | ...... | ...... | computed value of surrogate model is changed to computed value in optimization process | | |

It should be appreciated that, although the steps in the flow charts involved in the above embodiments are displayed in sequence as indicated by the arrows, these steps are not definitely executed in the order indicated by the arrows. Unless otherwise specified herein, there is no strict order limitation on the execution of these steps, and these steps may be executed in other orders. Moreover, at least a part of the steps in the flow charts involved in the above embodiments may include multiple steps or multiple stages. These steps or stages are not definitely executed at the same moment, but can be executed at different moments. The execution order of these steps or stages is not definitely sequential, but can be executed in turns or alternately with other steps or at least part of the steps or stages in other steps.

Based on the same inventive concept, in an embodiment of the present invention, a nuclear reactor design scheme optimization apparatus for implementing the above-mentioned nuclear reactor design scheme optimization method. The implementation solution to the problem provided by the apparatus is similar to the implementation solution described in the above method. Therefore, as for the specific limitations in one or more embodiments of the nuclear reactor design scheme optimization apparatus provided below, reference can be made to the limitations on the nuclear reactor design scheme optimization method above, which will not be repeated here.

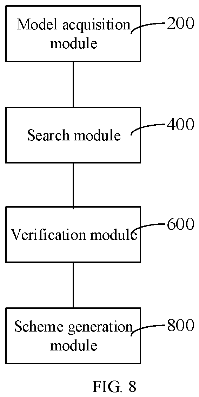

As shown in FIG. 8, the present invention further provides a nuclear reactor design scheme optimization apparatus, which may include:

a model acquisition module 200, configured to acquire a nuclear reactor overall machine learning model;
a search module 400, configured to search for a nuclear reactor design scheme using an optimization algorithm according to the nuclear reactor overall machine learning model, and obtain a search result of the nuclear reactor design scheme;
a verification module 600, configured to perform a verification regression on the search result of the nuclear reactor design scheme;
a scheme generation module 800, configured to generate a nuclear reactor design optimization scheme according to a verification regression result.

With the above-mentioned nuclear reactor design scheme optimization apparatus, the nuclear reactor overall machine learning model is acquired; a nuclear reactor design scheme is searched for using an optimization algorithm according to the nuclear reactor overall machine learning model, and a search result of the nuclear reactor design scheme is obtained; a verification regression is performed on the search result of the nuclear reactor design scheme; and a nuclear reactor design optimization scheme is generated according to a verification regression result. During the entire process, a variety of nuclear reactor design schemes are generated through the machine learning model, the scheme is searched for by using the optimization algorithm, and the verification regression is performed on the search result subsequently. Accordingly, the nuclear reactor design optimization scheme can be efficiently generated while ensuring that the schemes are accurately constructed.

In an embodiment, the model acquisition module 200 is further configured to: acquire nuclear reactor design scheme parameters; perform a nuclear reactor design automatic process analysis according to the nuclear reactor design scheme parameters, and obtain a nuclear reactor design process analysis result; generate a nuclear reactor design scheme database according to the nuclear reactor design process analysis result; train an initial supervised learning model according to the nuclear reactor design scheme database, and construct the nuclear reactor overall machine learning model.

In an embodiment, the model acquisition module 200 is further configured to acquire a nuclear reactor design parameter table, independently transform a design parameter in the nuclear reactor design parameter table, and obtain a nuclear reactor design scheme parameter.

In an embodiment, the search module 400 is further configured to: generate a plurality of nuclear reactor initial design schemes according to the nuclear reactor overall machine learning model; determine a design target, a design method, and a design criterion of the nuclear reactor, and establish an optimization mathematical model according to the design target, the design method and the design criterion of the nuclear reactor, the optimization mathematical model being configured to determine an optimization variable, an optimization target function, and an optimization constraint condition; perform nuclear reactor whole reactor parametric optimization problem solving on the plurality of nuclear reactor initial design schemes by using a composite optimization algorithm or a multi-target optimization algorithm according to the optimization mathematical model, and obtain a search result of the nuclear reactor design scheme.

In an embodiment, the verification module 600 is further configured to: perform a computational analysis on the search result of the nuclear reactor design scheme by using the nuclear reactor automatic process design, and obtain a computational analysis result; perform an iterative correction on the nuclear reactor overall machine learning model according to the computational analysis result, and obtain a corrected nuclear reactor overall machine learning model; output the latest corrected nuclear reactor overall machine learning model when a preset iterative correction stopping condition is satisfied; and verify the nuclear reactor design scheme corresponding to the latest corrected nuclear reactor overall machine learning model.

In an embodiment, the verification module 600 is further configured to: control the scheme generation module 800 to acquire a nuclear reactor design optimization scheme validated by the verification regression when a verification regression result is characterized as a validation; and when the verification regression result is characterized as a failure, control the search module 400 to re-execute the operation of searching for the nuclear reactor design scheme by using the optimization algorithm according to the nuclear reactor overall machine learning model and obtaining the search result of the nuclear reactor design scheme.

The modules in the above-mentioned nuclear reactor design scheme optimization apparatus can be fully or partially implemented by software, hardware and their combination. The above modules may be embedded in or independent of a processor in a computer device in the form of hardware, or may be stored in a memory in a computer device in the form of software, so that the processor can invoke and execute operations corresponding to the above modules.

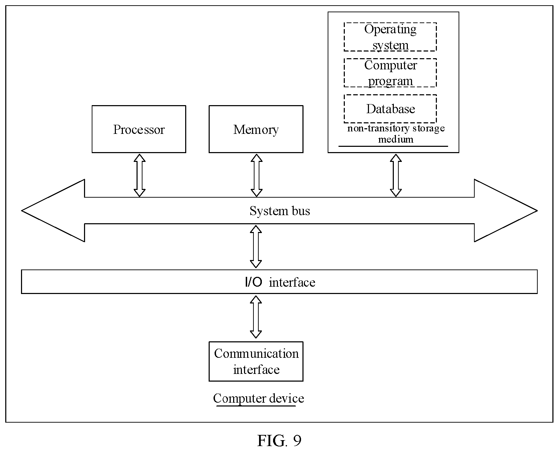

In an embodiment, a computer device is provided. The computer device may be a server, and an internal structure diagram thereof may be as shown in FIG. 9. The computer device may include a processor, a memory and a network interface connected to each other via a system bus. The processor of the computer device is configured to provide computing and controlling capabilities. The memory of the computer device may include a non-transitory storage medium and an internal memory. The non-transitory storage medium stores an operating system, a computer program, and a database. The internal memory provides an environment for the operation of the operating system and computer programs in the non-transitory storage medium. The database of the computer device is configured to store nuclear reactor design basic parameter data and nuclear reactor design scheme historical data. The network interface of the computer device is configured to communicate with an external terminal via a network connection. When the computer program is executed by a processor, a nuclear reactor design scheme optimization method is implemented.

Those skilled in the art will understand that the structure shown in FIG. 9 is merely a block diagram of a partial structure related to the solution of the present invention, and does not constitute a limitation on the computer device to which the solution of the present invention is applied. The specific computer device may include more or fewer components than shown in the figure, or combine certain components, or have a different arrangement of components.

A computer device includes one or more processors and a memory storing computer-readable instructions. When the computer-readable instructions are executed by the processor, the one or more processors execute the steps in the above-mentioned nuclear reactor design scheme optimization method.

One or more computer storage media storing computer-readable instructions, which, when executed by one or more processors, cause the one or more processors to execute the steps in the above-mentioned nuclear reactor design scheme optimization method.

A computer program product includes a computer program, the computer program, when executed by a processor, may cause the processor to implement the steps in the above-mentioned nuclear reactor design scheme optimization method.

It should be noted that user information (including but not limited to user device information, user personal information, etc.) and data (including but not limited to data used for analysis, stored data, displayed data, etc.) involved in the present application are all information and data authorized by the user or fully authorized by all parties.

A person of ordinary skill in the art should appreciate that all or part of the processes in the above-mentioned method embodiments can be implemented by instructing related hardware through a computer program. The computer program can be stored in a non-transitory computer-readable storage medium. When the computer program is executed, the processes in the above-mentioned method embodiments may be included. Any reference to a memory, a database, or other medium used in the embodiments provided in the present invention may include at least one of a non-transitory memory and a transitory memory. The non-transitory memory may include a read-only memory (ROM), a magnetic tape, a floppy disk, a flash memory, an optical storage, a high-density embedded non-transitory memory, a resistive random access memory (ReRAM), a magnetoresistive random access memory (MRAM), a ferroelectric random access memory (FRAM), a phase change memory (PCM), a graphene memory, etc. The transitory memory may include a random access memory (RAM) or an external cache memory, etc. By way of illustration and not limitation, the RAM may be in various forms, such as a static random access memory (SRAM) or a dynamic random access memory (DRAM). The database involved in each embodiment provided in the present invention may include at least one of a relational database and a non-relational database. The non-relational databases may include, but not limited to, distributed databases based on blockchain. The processor involved in each embodiment provided in the present invention may be a general-purpose processor, a central processing unit, a graphics processor, a digital signal processor, a programmable logic unit, a data processing logic unit based on quantum computing, etc., which is not limited thereto.

The technical features in the above embodiments can be arbitrarily combined. In order to make the description concise, all possible combinations of the technical features in the above embodiments are not described. However, as long as there is no contradiction in the combinations of these technical features, these combinations should be regarded as falling within the scope of the present invention.

**Claims**

1. A nuclear reactor design scheme optimization method, **characterized by** comprising:

    acquiring a nuclear reactor overall machine learning model;
    searching for a nuclear reactor design scheme with an optimization algorithm according to the nuclear reactor overall machine learning model, obtaining a search result of the nuclear reactor design scheme;
    performing a verification regression on the search result of the nuclear reactor design scheme; and
    generating a nuclear reactor design optimization scheme according to a verification regression result.

2. The method according to claim 1, wherein the acquiring the nuclear reactor overall machine learning model comprises:

    acquiring nuclear reactor design parameters;
    performing a nuclear reactor design automatic process analysis according to the nuclear reactor design scheme parameters, obtaining a nuclear reactor design process analysis result;
    generating a nuclear reactor design scheme database according to the nuclear reactor design process analysis result; and
    training an initial supervised learning model according to the nuclear reactor design scheme database, and constructing the nuclear reactor overall machine learning model.

3. The method according to claim 2, wherein the acquiring nuclear reactor design parameters comprises:

    acquiring a nuclear reactor parameter table; and
    independently transforming design parameters in the nuclear reactor design parameter table, and obtaining the nuclear reactor design scheme parameters.

4. The method according to claim 1, wherein the searching for the nuclear reactor design scheme with the optimization algorithm according to the nuclear reactor overall machine learning model and obtaining the search result of the nuclear reactor design scheme comprises:
    searching for the nuclear reactor design scheme with a composite multi-optimization method according to the nuclear reactor overall machine learning model, and obtaining the search result of the nuclear reactor design scheme.

5. The method according to claim 1, wherein the searching for the nuclear reactor design scheme with the optimization algorithm according to the nuclear reactor overall machine learning model and obtaining the search result of the nuclear reactor design scheme comprises:
    searching for the nuclear reactor design scheme with a multi-target optimization algorithm according to the nuclear reactor overall machine learning model, and obtaining the search result of the nuclear reactor design scheme.

6. The method according to claim 1, wherein the searching for the nuclear reactor design scheme with the optimization algorithm according to the nuclear reactor overall machine learning model and obtaining the search result of the nuclear reactor design scheme comprises:

generating a plurality of nuclear reactor initial design schemes according to the nuclear reactor overall machine learning model;

determining a design target, a design method, and a design criterion of the nuclear reactor, and establishing an optimization mathematical model according to the design target, the design method and the design criterion of the nuclear reactor, wherein the optimization mathematical model is configured to determine an optimization variable, an optimization target function, and an optimization constraint condition; and

performing nuclear reactor whole reactor parametric optimization problem solving on the plurality of nuclear reactor initial design schemes by using a composite optimization algorithm or a multi-target optimization algorithm according to the optimization mathematical model, and obtaining the search result of the nuclear reactor design scheme.

7. The method according to claim 1, wherein the performing the verification regression on the search result of the nuclear reactor design scheme comprises:

performing a computational analysis on the search result of the nuclear reactor design scheme by using the nuclear reactor automatic process design, obtaining a computational analysis result;

performing an iterative correction on the nuclear reactor overall machine learning model according to the computational analysis result, and obtaining a corrected nuclear reactor overall machine learning model;

outputting the latest corrected nuclear reactor overall machine learning model when a preset iterative correction stopping condition is satisfied; and

verifying a nuclear reactor design scheme corresponding to the latest corrected nuclear reactor overall machine learning model.

8. The method according to claim 1, further comprising:

acquiring a nuclear reactor design optimization scheme validated by the verification regression when a verification regression result is characterized as a validation; and

when the verification regression result is characterized as a failure, re-executing the step of searching for the nuclear reactor design scheme by using the optimization algorithm according to the nuclear reactor overall machine learning model and obtaining the search result of the nuclear reactor design scheme.

9. A nuclear reactor design scheme optimization apparatus, **characterized by** comprising:

a model acquisition module, configured to acquire a nuclear reactor overall machine learning model;

a search module, configured to search for a nuclear reactor design scheme using an optimization algorithm according to the nuclear reactor overall machine learning model, and obtain a search result of the nuclear reactor design scheme;

a verification module, configured to perform a verification regression on the search result of the nuclear reactor design scheme; and

a scheme generation module, configured to generate a nuclear reactor design optimization scheme according to a verification regression result.

10. The apparatus according to claim 9, wherein the model acquisition module is further configured to:

acquire nuclear reactor design parameters;

perform a nuclear reactor design automatic process analysis according to the nuclear reactor design scheme parameters, and obtain a nuclear reactor design process analysis result;

generate a nuclear reactor design scheme database according to the nuclear reactor design process analysis result; and

train an initial supervised learning model according to the nuclear reactor design scheme database, and construct the nuclear reactor overall machine learning model.

11. The apparatus according to claim 10, wherein the model acquisition module is further configured to acquire a nuclear reactor parameter table, independently transform design parameters in the nuclear reactor design parameter table, and obtain the nuclear reactor design scheme parameters.

12. The apparatus according to claim 9, wherein the search module is further configured to search for the nuclear reactor design scheme with a composite multi-optimization method according to the nuclear reactor overall machine learning model, and obtain the search result of the nuclear reactor design scheme.

13. The apparatus according to claim 9, wherein the search module is further configured to search for the nuclear reactor design scheme with a multi-target optimization algorithm according to the nuclear reactor overall machine learning model, and obtain the search result of the nuclear reactor design scheme.

14. The apparatus according to claim 9, wherein the search module is further configured to:

generate a plurality of nuclear reactor initial design schemes according to the nuclear reactor overall machine learning model;
determine a design target, a design method, and a design criterion of the nuclear reactor, and establish an optimization mathematical model according to the design target, the design method and the design criterion of the nuclear reactor, wherein the optimization mathematical model is configured to determine an optimization variable, an optimization target function, and an optimization constraint condition; and
perform nuclear reactor whole reactor parametric optimization problem solving on the plurality of nuclear reactor initial design schemes by using a composite optimization algorithm or a multi-target optimization algorithm according to the optimization mathematical model, and obtain the search result of the nuclear reactor design scheme.

15. The apparatus according to claim 9, wherein the verification module is further configured to:

perform a computational analysis on the search result of the nuclear reactor design scheme by using the nuclear reactor automatic process design, obtain a computational analysis result;
perform an iterative correction on the nuclear reactor overall machine learning model according to the computational analysis result, and obtain a corrected nuclear reactor overall machine learning model;
output the latest corrected nuclear reactor overall machine learning model when a preset iterative correction stopping condition is satisfied; and
verify a nuclear reactor design scheme corresponding to the latest corrected nuclear reactor overall machine learning model.

16. The apparatus according to claim 9, wherein the verification module is further configured to:

acquire a nuclear reactor design optimization scheme validated by the verification regression when a verification regression result is characterized as a validation; and
when the verification regression result is characterized as a failure, control the search module to re-execute operations of searching for the nuclear reactor design scheme by using the optimization algorithm according to the nuclear reactor overall machine learning model and obtaining the search result of the nuclear reactor design scheme.

17. A computer device, comprising one or more processors and a memory storing computer-readable instructions, wherein the computer-readable instructions, when executed by the one or more processors, cause the one or more processors to implement steps of:

acquiring a nuclear reactor overall machine learning model;
searching for a nuclear reactor design scheme with an optimization algorithm according to the nuclear reactor overall machine learning model, obtaining a search result of the nuclear reactor design scheme;
performing a verification regression on the search result of the nuclear reactor design scheme; and
generating a nuclear reactor design optimization scheme according to a verification regression result.

18. The computer device according to claim 17, wherein the acquiring the nuclear reactor overall machine learning model comprises:

acquiring nuclear reactor design parameters;
performing a nuclear reactor design automatic process analysis according to the nuclear reactor design scheme parameters, obtaining a nuclear reactor design process analysis result;
generating a nuclear reactor design scheme database according to the nuclear reactor design process analysis result; and
training an initial supervised learning model according to the nuclear reactor design scheme database, and constructing the nuclear reactor overall machine learning model.

19. One or more computer storage media, on which computer-readable instructions are stored, wherein the computer-readable instructions, when executed by the one or more processors, cause the one or more processors to implement steps of:

acquiring a nuclear reactor overall machine learning model;
searching for a nuclear reactor design scheme with an optimization algorithm according to the nuclear reactor overall machine learning model, obtaining a search result of the nuclear reactor design scheme;
performing a verification regression on the search result of the nuclear reactor design scheme; and
generating a nuclear reactor design optimization scheme according to a verification regression result.

20. A computer program product, comprising a computer program, wherein the computer program, when executed by a processor, causes the processor to implement steps of:

acquiring a nuclear reactor overall machine learning model;
searching for a nuclear reactor design scheme with an optimization algorithm according to the nuclear reactor overall machine learning model, obtaining a search result of the nuclear reactor design scheme;
performing a verification regression on the search result of the nuclear reactor design scheme; and
generating a nuclear reactor design optimization scheme according to a verification regression result.

FIG. 1

| a nuclear reactor overall machine learning model is acquired | S200 |

| a nuclear reactor design scheme is searched for with an optimization algorithm according to the nuclear reactor overall machine learning model, a search result of the nuclear reactor design scheme is obtained | S400 |

| a verification regression is performed on the search result of the nuclear reactor design scheme | S600 |

| a nuclear reactor design optimization scheme is generated according to a verification regression result | S800 |

FIG. 2

nuclear reactor design parameters are acquired — S220

↓

a nuclear reactor design automatic process analysis is performed according to the nuclear reactor design scheme parameters, and a nuclear reactor design process analysis result is obtained — S240

↓

a nuclear reactor design scheme database is generated according to the nuclear reactor design process analysis result — S260

↓

an initial supervised learning model is trained according to the nuclear reactor design scheme database, and the nuclear reactor overall machine learning model is constructed — S280

FIG. 3

a plurality of nuclear reactor initial design schemes are generated according to the nuclear reactor overall machine learning model — S420

↓

a design target, a design method, and a design criterion of the nuclear reactor are determined, and an optimization mathematical model is established according to the design target, the design method and the design criterion of the nuclear reactor. The optimization mathematical model is configured to determine an optimization variable, an optimization target function, and an optimization constraint condition — S440

↓

Nuclear reactor whole reactor parametric optimization problem solving is performed on the plurality of nuclear reactor initial design schemes by using a composite optimization algorithm or a multi-target optimization algorithm according to the optimization mathematical model, and the search result of the nuclear reactor design scheme is obtained — S460

FIG. 4

Solution setting parameter, target function, constraint condition

Non-dominated sorting is performed on initialization schemes P0

Individuals are selected for genetic operation

Subgeneration scheme Xn is generated

Normal distribution crossover

Pn and Xn are merged to generate Qn, non-dominated sorting operation is performed on Qn

Adaptive adjustment of mutation

Number of subgenerations N reaches limit value

Yes

Optimal scheme is output

FIG. 5

a computational analysis is performed on the search result of the nuclear reactor design scheme by using the nuclear reactor automatic process design, and a computational analysis result is obtained — S620

an iterative correction is performed on the nuclear reactor overall machine learning model according to the computational analysis result, and a corrected nuclear reactor overall machine learning model is obtained — S640

when a preset iterative correction stopping condition is satisfied, the latest corrected nuclear reactor overall machine learning model is outputted — S660

a nuclear reactor design scheme corresponding to the latest corrected nuclear reactor overall machine learning model is verified — S680

FIG. 6

```
                    ┌─────────────────────────────┐
                    │        Scheme input         │
                    └──────────────┬──────────────┘
                                   │
   ┌───────────────────────────────┼──────────────────────────────────────┐
   │       ┌──────────────────┐     Fail to meet condition                 │
   │       │ Keff surrogate   ├───────────────────────────────────┐        │
   │       │ model            │                                   │        │
   │       └────────┬─────────┘                                   │        │
   │                │                                             │        │
   │       ┌────────┴─────────┐     Fail to meet condition        │        │
   │       │ Sub-channel      ├───────────────────────────────────┤        │
   │       │ surrogate model  │                                   │        │
   │       └────────┬─────────┘                                   │        │
   │                │                                             │        │
   │       ┌────────┴─────────┐     Fail to meet condition        │        │
   │       │ Service life     ├───────────────────────────────────┤        │
   │       │ surrogate model  │                                   │        │
   │       └────────┬─────────┘                                   │        │
   │                │                                             │        │
   │       ┌────────┴─────────┐             ┌─────────────────────┴──────┐ │
   │       │ Uranium loading  │             │    Ineffective scheme      │ │
   │       │ computation      │             └─────────────┬──────────────┘ │
   │       └────────┬─────────┘                           │                │
   │                └──────────────────────┬──────────────┘                │
   └───────────────────────────────────────┼───────────────────────────────┘
                                            │
                             ┌──────────────┴──────────────┐
                             │        Result output        │
                             └─────────────────────────────┘

                                    FIG. 7
```

```
┌─────────────────────┐
│  Model acquisition  │──200
│       module        │
└─────────────────────┘
           │
┌─────────────────────┐
│   Search module     │──400
│                     │
└─────────────────────┘
           │
┌─────────────────────┐
│ Verification module │──600
│                     │
└─────────────────────┘
           │
┌─────────────────────┐
│ Scheme generation   │──800
│       module        │
└─────────────────────┘
```

FIG. 8

FIG. 9

# INTERNATIONAL SEARCH REPORT

| International application No. |
|---|
| **PCT/CN2022/125854** |

## A. CLASSIFICATION OF SUBJECT MATTER

G06F 30/27(2020.01)i

According to International Patent Classification (IPC) or to both national classification and IPC

## B. FIELDS SEARCHED

Minimum documentation searched (classification system followed by classification symbols)

G06F

Documentation searched other than minimum documentation to the extent that such documents are included in the fields searched

Electronic data base consulted during the international search (name of data base and, where practicable, search terms used)

CNTXT, USTXT, WOTXT, CNABS, CNKI: 核反应堆, 设计, 优化, 方案, 机器学习, 模型, 算法, 训练, 验证, 回归, machine, learn+, model, train+, nuclear, reactor, design, scheme, verif+, return+

## C. DOCUMENTS CONSIDERED TO BE RELEVANT

| Category* | Citation of document, with indication, where appropriate, of the relevant passages | Relevant to claim No. |
|---|---|---|
| PX | CN 114444383 A (LINGDONG NUCLEAR POWER CO., LTD. et al.) 06 May 2022 (2022-05-06)<br>claims 1-10, and description, paragraphs [0062]-[0119] | 1-20 |
| X | US 2021271793 A1 (BWXT ADVANCED TECHNOLOGIES LLC.) 02 September 2021 (2021-09-02)<br>description, paragraphs [0052]-[0118] | 1-20 |
| A | CN 109978166 A (UNIVERSITY OF SOUTH CHINA) 05 July 2019 (2019-07-05)<br>entire document | 1-20 |
| A | CN 113761802 A (CHENGDU CAIZHI TECHNOLOGY CO., LTD.) 07 December 2021 (2021-12-07)<br>entire document | 1-20 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **03 January 2023** | **18 January 2023** |

| Name and mailing address of the ISA/CN | Authorized officer |
|---|---|
| **China National Intellectual Property Administration (ISA/CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
**Information on patent family members**

International application No.

**PCT/CN2022/125854**

| Patent document cited in search report | | | Publication date (day/month/year) | Patent family member(s) | | | Publication date (day/month/year) |
|---|---|---|---|---|---|---|---|
| CN | 114444383 | A | 06 May 2022 | None | | | |
| US | 2021271793 | A1 | 02 September 2021 | CA | 3163579 | A1 | 22 July 2021 |
| | | | | WO | 2021146361 | A1 | 22 July 2021 |
| | | | | KR | 20220124769 | A | 14 September 2022 |
| | | | | CN | 115210822 | A | 18 October 2022 |
| | | | | EP | 4091179 | A1 | 23 November 2022 |
| CN | 109978166 | A | 05 July 2019 | None | | | |
| CN | 113761802 | A | 07 December 2021 | None | | | |

Form PCT/ISA/210 (patent family annex) (January 2015)

**REFERENCES CITED IN THE DESCRIPTION**

**Patent documents cited in the description**

- CN 202111676363